# EUROPÄISCHE PATENTSCHRIFT

(11) **EP 2 041 874 B1**
(45) Veröffentlichungstag und Bekanntmachung des Hinweises auf die Patenterteilung: **05.01.2011**
(21) Anmeldenummer: 07764410.2
(22) Anmeldetag: 29.06.2007
(51) Int. Cl.: H03M 3/00, H03M 1/06, G01R 33/07, H01L 43/04, H03F 3/45

(54) **VERFAHREN ZUR VERARBEITUNG VON OFFSET-BEHAFTETEN SENSORSIGNALEN SOWIE FÜR DIE DURCHFÜHRUNG DES VERFAHRENS AUSGEBILDETE SENSORANORDNUNG**
METHOD FOR PROCESSING SENSOR SIGNALS SUBJECT TO AN OFFSET AND SENSOR ARRANGEMENT DESIGNED TO CARRY OUT THE METHOD
PROCÉDÉ DE TRAITEMENT DE SIGNAUX DE CAPTEUR PRÉSENTANT UN DÉCALAGE ET DISPOSITIF CAPTEUR CONÇU POUR LA RÉALISATION DU PROCÉDÉ

(30) Priorität: 14.07.2006 DE 102006032760; 15.12.2006 DE 102006059421
(43) Veröffentlichungstag der Anmeldung: 01.04.2009
(73) Patentinhaber: Fraunhofer-Gesellschaft zur Förderung der angewandten Forschung e.V., 80686 München (DE)
(72) Erfinder: HACKNER, Michael, 93155 Hemau (DE); HOHE, Hans-Peter, 91332 Heiligenstadt (DE)
(74) Vertreter: Gagel, Roland
(86) Internationale Anmeldenummer: PCT/DE2007/001157
(87) Internationale Veröffentlichungsnummer: WO 2008/006337

(56) Entgegenhaltungen:
- EP-A- 1 637 898
- WO-A-02/03087
- ANTON BAKKER ET AL: "A CMOS Nested-Chopper Instrumentation Amplifier with 100-nV Offset" IEEE JOURNAL OF SOLID-STATE CIRCUITS, IEEE SERVICE CENTER, PISCATAWAY, NJ, US, Bd. 35, Nr. 12, Dezember 2000 (2000-12), XP011061382 ISSN: 0018-9200 in der Anmeldung erwähnt

## Beschreibung

### Technisches Anwendungsgebiet

Die vorliegende Erfindung betrifft ein Verfahren zur Verarbeitung von mit einem Offset behafteten Sensorsignalen eines Sensors, der in mehreren Messzyklen mit jeweils 2n (n=1,2...) aufeinander folgenden Phasen mit unterschiedlicher Ansteuerung betrieben wird, bei dem die Sensorsignale der einzelnen Phasen in einem Verstärker verstärkt und anschließend mit einem Analog/Digital-Wandler digitalisiert werden, und bei dem die verstärkten digitalisierten Signale der einzelnen Phasen jedes Messzyklus aufsummiert werden, um für jeden Messzyklus ein Offset-reduziertes Ausgangssignal zu erhalten, wobei die Sensorsignale vor der Verstärkung in einem Modulator moduliert und nach der Verstärkung in einem Demodulator wieder demoduliert werden. Die Erfindung betrifft auch eine Sensoranordnung, die für die Durchführung des Verfahrens ausgebildet ist.

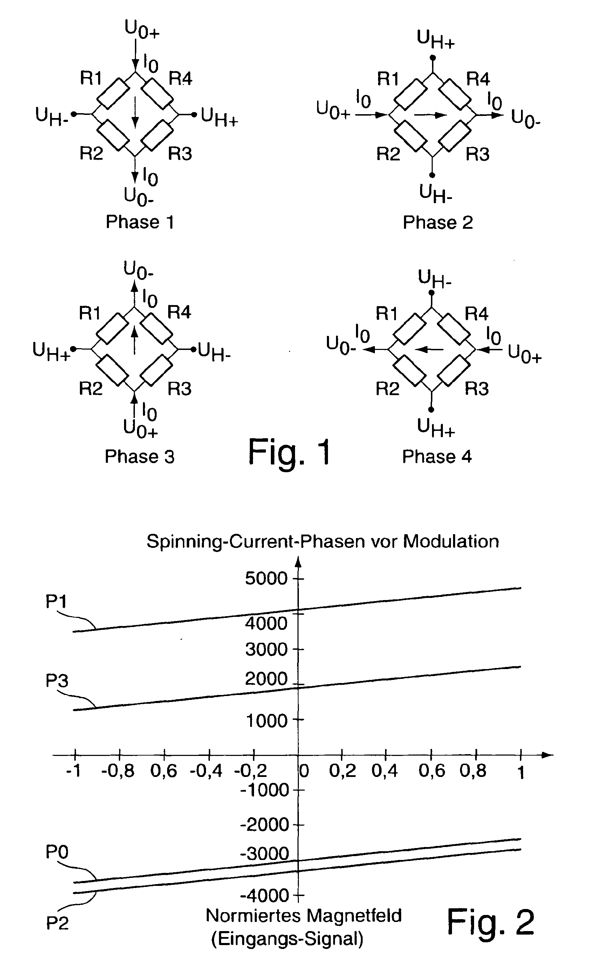

Bei nahezu allen Sensoranwendungen tritt ein Offset des Sensorsignals auf, der sowohl durch die Herstellung als auch durch andere äußere Einflüsse bedingt sein kann. Eine Reduzierung oder Kompensation dieses Offset ist zur Erhöhung der Messgenauigkeit von großer Bedeutung. Eine bekannte Technik zur Offset-Kompensation, wie sie vor allem bei Hall-Sensoren eingesetzt wird, ist die so genannte Spinning-Current-Technik. Voraussetzung für eine gute Offset-Unterdrückung mit dieser Technik ist eine zumindest 4-fache Rotationssymmetrie des Hall-Elements. Die Länge und Breite des Elements müssen hierzu gleich sein und die Kontakte für die Einprägung des Steuerstroms I₀ bzw. der Steuerspannung U₀ und den Abgriff der Hall-Spannung U_{H} = U_{H+} - U_{H-} müssen identisch aufgebaut sein. Bei Hall-Elementen mit vier Kontakten kann der Steuerstrom dann in vier verschiedenen Richtungen eingeprägt und senkrecht dazu die Hall-Spannung abgegriffen werden. Dies ist anhand der schematischen Darstellung der vier so genannten Spinning-Current-Phasen der Fig.1 veranschaulicht, in denen jeweils das Ersatzschaltbild eines symmetrischen Hall-Elementes mit vier Kontakten dargestellt ist. Ein Messzyklus besteht aus den dargestellten vier Phasen, die sich durch die unterschiedliche Ansteuerung des Hall-Elementes unterscheiden. Werden die Messergebnisse dieser vier Spinning-Current-Phasen jedes Messzyklus aufsummiert, dann wird der Offset im Verhältnis zum Signal etwa um den Faktor 100 bis 1000 reduziert.

Neben der Nutzung von vier unterschiedlichen Phasen sind auch Spinning-Current-Techniken bekannt, bei denen Hall-Sensoren in acht Phasen angesteuert werden. Dies erfordert entsprechend ausgestaltete Hall-Elemente mit 8-facher Rotationssymmetrie und acht Kontakten, wobei dann der Steuerstrom und die Hall-Spannung von Phase zu Phase nicht jeweils um 90° wie im Falle der 4-Phasen-Betriebsweise, sondern um 45° rotiert werden. Prinzipiell sind beliebige Rotationswinkel möglich, wobei zur Reduzierung des Offset jedoch nur Rotationswinkel von 360°/(4*n) sinnvoll sind (n = 1, 2,...).

Zur Durchführung des Spinning-Current-Verfahrens ist zunächst die Messung der einzelnen Hall-Anteile erforderlich, die den jeweiligen Einzelphasen-Offset und den magnetischen Signal-Hub für jede Phase enthalten. Der Einzelphasen-Offset ist jedoch in der Regel im Vergleich zum magnetischen Signal-Hub, d.h. der gewünschten Messgröße, sehr groß. Dies zeigt beispielhaft die Messung der Fig. 2, in der nach rechts das normierte Magnetfeld und nach oben die Ausgangsspannung des Hall-Elementes nach der Digitalisierung aufgetragen sind. Die gestrichelten Linien entsprechen der digitalisierten Spannung zwischen den Hall-Kontakten in der jeweiligen Spinning-Current-Phase P0-P3 in Digits des eingesetzten Analog/Digital-Wandlers (ADU). Die durchgezogene Linie stellt den Mittelwert dieser vier Spannungen mit dem Faktor 10 skaliert dar. Dies entspricht somit dem Ergebnis nach der Summation über die vier Phasen, also dem Offset-korrigierten Messergebnis bei Einsatz der Spinning-Current-Technik. Wie aus der Fig. 2 ersichtlich, ist bei dieser Messung der Einzelphasen-Offset größer als der magnetische Signal-Hub. Der ADU wird demnach hauptsächlich durch den Offset der Einzelphasen ausgesteuert. Da eine Übersteuerung vermieden werden muss, kann die Verstärkung des in der Regel zwischen dem Sensor und dem ADU eingesetzten Verstärkers nicht an das magnetisch induzierte Ausgangssignal des Sensors angepasst werden. Sie muss unter Berücksichtigung des Einzelphasen-Offset gewählt werden. Somit wird die Auflösung der Analog/Digital-Umsetzung vorwiegend durch die Einzelphasen-Offsets und nicht durch den Signal-Hub begrenzt. Dies reduziert die Auflösung und damit die Messgenauigkeit.

Werden zur weiteren Verarbeitung des SensorSignals Verstärker eingesetzt, dann kommt durch diese Verstärker häufig ein zusätzlicher Offset im Signalpfad hinzu, der sich zu den Einzelphasen-Offsets addiert. Da die Offsets der Hall-Elemente und des Verstärkers stochastisch, in der Regel Gauß'sch, über alle gefertigten Systeme verteilt sind, erhöht sich der Erwartungswert des Gesamt-Offset nicht linear. Er berechnet sich vielmehr durch die Bildung des quadratischen Mittels der beiden Effektivwerte. Dennoch tritt durch den Verstärker eine Erhöhung des Erwartungswertes des gesamten Offset ein, wodurch die Auflösung des magnetischen Signals durch den ADU weiter vermindert wird.

Zur Korrektur des Offset des Verstärkers sind unterschiedliche Verfahren bekannt. Die wichtigsten dieser Verfahren sind die Offset-Kalibrierung oder Trimmung, das so genannte Auto-Zero oder Correlated Double Sampling (CDS) sowie das Chopper-Verfahren.

Während durch die Offset-Kalibrierung eine Drift des Offset nach der Trimmung nicht verhindert werden kann, lassen sich mit dem Auto-Zero und dem Chopper-Verfahren auch derartige Offsets kompensieren oder zumindest vermindern. Beim Chopper-Verfahren wird das Eingangssignal vor dem Verstärker moduliert und nach dem Verstärker wieder demoduliert. Im einfachsten Fall bei symmetrischen Signalen wird der Modulator über Schalter realisiert, so dass das Eingangssignal einmal invertiert und einmal nicht invertiert auf den Eingang des Verstärkers geschaltet wird. Die Signalverarbeitung am Ausgang erfolgt äquivalent, so dass das Signal unverändert durchgelassen wird. Der Verstärker-Offset und das 1/f-Rauschen können jedoch stark reduziert werden, da sie auf die Chopper-Frequenz und deren Vielfache hochmoduliert werden. Das nachfolgende Tiefpassfilter (LPF) entfernt diese Anteile.

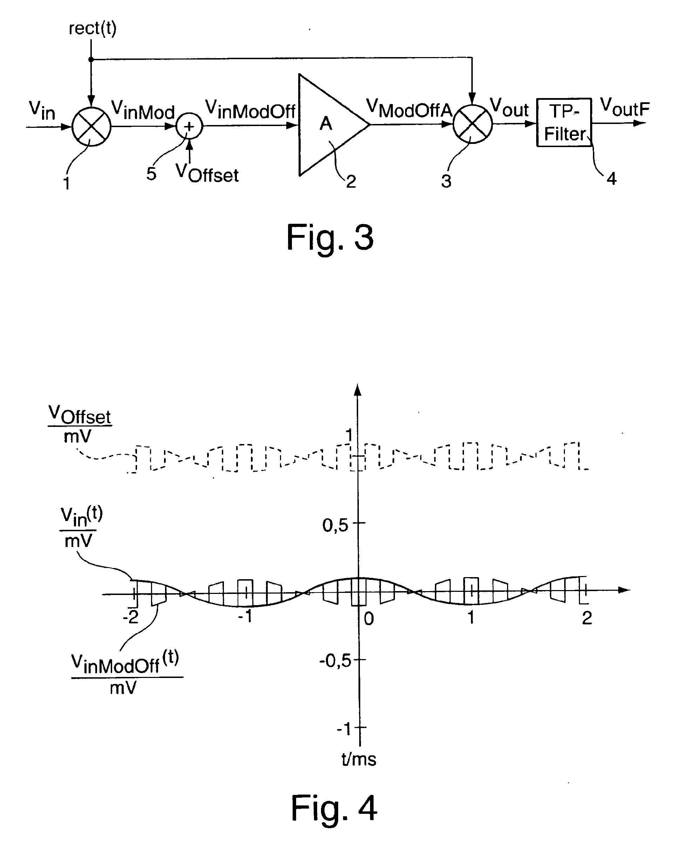

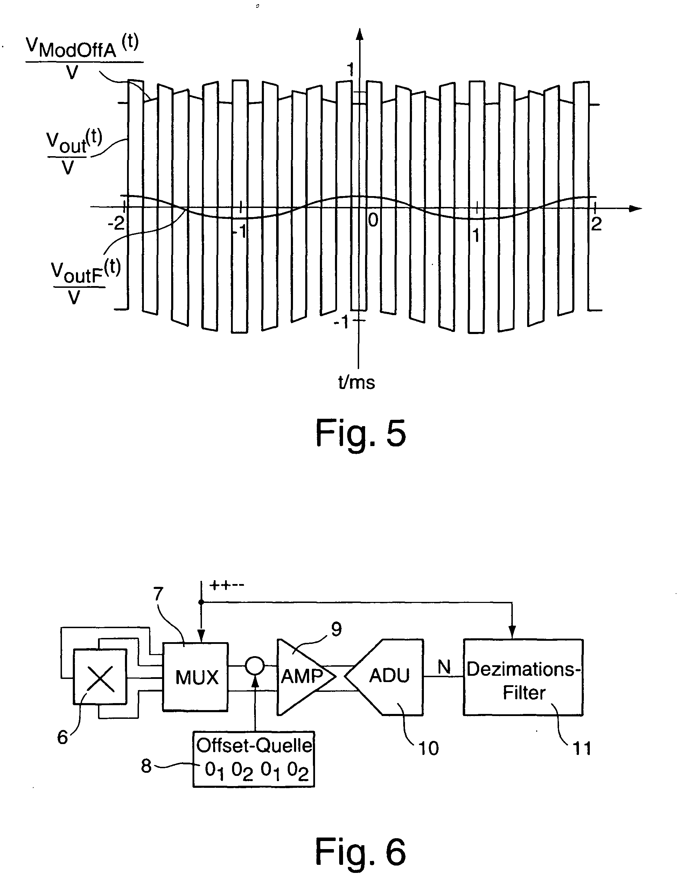

Bei kleinen Eingangssignalen, deren Amplitude deutlich geringer ist als der Eingangs-bezogene Offset des Verstärkers ohne Chopper, ist die maximal mögliche Verstärkung jedoch auch hier bereits durch den Eigen-Offset des Verstärkers begrenzt. Dies wird anhand der Fig. 3 bis 5 erläutert. Fig. 3 zeigt hierbei die Modulation des Eingangssignals Vᵢₙ mit dem Modulator 1, dem Verstärker 2, dem Demodulator 3 zur Demodulation des verstärkten Signals sowie den nachgeschalteten Tiefpassfilter 4, mit dem die Anteile des Verstärker-Offset sowie des 1/f-Rauschens eliminiert werden. Der Offset des Verstärkers 2 ist hierbei durch die Offset-Quelle 5 angedeutet. Im vorliegenden Beispiel wird ein sinusförmiges Eingangssignal von 0,1 mV Amplitude ohne Offset angenommen. Der Offset-behaftete innen liegende Verstärker 2 wird durch einen Offset-losen Verstärker und eine Eingangs-äquivalente Offset-Spannungsquelle moduliert. Aus dem Eingangssignal Vᵢₙ (ohne Offset) wird ein über rect(t) Rechteck-moduliertes Signal V_{inMod}, das das Eingangssignal Vᵢₙ als Einhüllende besitzt. Wie man in dem Diagramm der Fig. 4 erkennen kann, wird die Eingangs-Aussteuerung vom Offset dominiert. Auch am Ausgang des Verstärkers 2 überwiegt der Offset den Nutz-Signal-Anteil, wie in der Fig. 5 zu erkennen ist. Wie man leicht sieht, ist der Aussteuerbereich vor dem Tiefpassfilter 4 aufgrund des Offset 11 mal höher als er aufgrund des Nutzsignals sein müsste. Als Tiefpass wurde ein gleitendes Mittelwert-Filter verwendet, dessen Integrationsintervall exakt einer Periode des Modulationssignals rect(t) entspricht.

Ein Nachteil der Kompensation mit Schaltern, wie beim Chopper-Verfahren, ist ein zusätzlicher Offset-Anteil, der durch Ladungs-Injektion in den Schaltern entsteht. Zwar wird der eigentliche Offset des Verstärkers deutlich reduziert, durch parasitäre Kapazitäten der Schalter wird jedoch zusätzliche Ladung in die Signalpfade injiziert, die sich als zusätzlicher Offset äußert. Um diesem Effekt entgegen zu wirken ist es bekannt, eine zweite Chopper-Anordnung um einen Chopper-Verstärker einzusetzen, die mit geringerer Frequenz angesteuert wird, um damit den durch Ladungs-Injektion hervorgerufenen Offset auch noch zu eliminieren. Dies wird beispielsweise in A. Bakker et al., "A CMOS Nested-Chopper Instrumentation Amplifier with 100-nV Offset", IEEE Journal of Solid-State Circuits, Vol. 35, No. 12, December 2000, Seiten 1877 bis 1883, näher erläutert.

Bei diesem und den anderen bekannten Verfahren zur Reduzierung des Verstärker-Offset wird nur der Offset des Verstärkers selbst reduziert bzw. elminiert. Offset-Anteile, die in der Signalquelle vor dem Verstärker entstehen, werden durch diese Maßnahmen nicht berührt. Sie werden im Falle der Hall-Sensoren durch das Spinning-Current-Verfahren wirkungsvoll reduziert. Allerdings besteht trotz dieser bereits signifikanten Reduktion des Offset gerade bei Hall-Elementen der Wunsch nach einer weiteren Erhöhung der Messgenauigkeit.

EP 1637 898 offenbart ein Magnetfeldsensor mit kontinuierlicher Kalibrierung, umfassend einen Referenz-Magnetfeld-Generator, einen Magnetfeldsensor mit einem oder mehreren Hall-Sensoren, eine Signalverarbeitungseinheit, die and den Ausgang des Magnetfeldsensors angeschlossen ist, sowie eine oder mehrere Feedback-Leitungen zur Korrektur von Fehlerfluktuationen in der Übertragungscharakteristik des Magnetfeldsensors. Namentlich, es offenbart einen Verfahren zur Verarbeitung von mit einem Offset behafteten Sensorsignalen eines Sensors, der in mehreren Messzyklen mit jeweils 2n (n=1, 2 ...) aufeinander folgenden Phasen mit unterschiedlicher Ansteuerung betrieben wird, bei dem die Sensorsignale der einzelnen Phasen in einem Verstärker verstärkt und für jedes Messzyklus aufsummiert werden, um für jeden Messzyklus ein Offset-reduziertes Ausgangssignal zu erhalten, wobei die Sensorsignale vor der Verstärkung in einem Modulator moduliert und nach der Verstärkung in einem Demodulator wieder demoduliert werden, wobei durch die Modulation die Sensorsignale von n Phasen jedes Messzyklus mit negativem Vorzeichen und die Sensorsignale der verbleibenden n Phasen des Messzyklus mit positivem Vorzeichen gewichtet werden.

Die Aufgabe der vorliegenden Erfindung besteht daher darin, für Sensoren, die in mehreren Messzyklen mit mehreren aufeinander folgenden Phasen mit unterschiedlicher Ansteuerung betrieben werden, ein Verfahren zur Verarbeitung der Sensor-Signale anzugeben, das eine weitere Erhöhung der Messgenauigkeit ermöglicht. Weiterhin soll eine Sensor-Anordnung bereitgestellt werden, die die Durchführung des Verfahrens ermöglicht.

### Darstellung der Erfindung

Die Aufgabe wird mit dem Verfahren und der Sensoranordnung gemäß den Patentansprüchen 1 und 5 gelöst. Vorteilhafte Ausgestaltungen des Verfahrens sowie der Sensoranordnung sind Gegenstand der Unteransprüche oder lassen sich der nachfolgenden Beschreibung sowie den Ausführungsbeispielen entnehmen.

Bei dem vorgeschlagenen Verfahren zur Verarbeitung von mit einem Offset behafteten Sensorsignalen eines Sensors, der in mehreren Messzyklen mit jeweils 2n (n=1,2,...) aufeinander folgenden Phasen mit unterschiedlicher Ansteuerung betrieben wird, werden die Sensorsignale der einzelnen Phasen in bekannter Weise in einem Verstärker verstärkt und anschließend mit einem Analog/Digital-Wandler digitalisiert. Die verstärkten und digitalisierten Signale der einzelnen Phasen jedes Messzyklus werden aufsummiert, um für jeden Messzyklus ein Offset-reduziertes Ausgangssignal zu erhalten. Die Sensorsignale werden bei dem vorliegenden Verfahren vor der Verstärkung in einem Modulator derart moduliert, dass die Sensorsignale von n-Phasen jedes Messzyklus mit negativem Vorzeichen und die Sensor-Signale der verbleibenden n-Phasen des Messzyklus mit positivem Vorzeichen gewichtet werden. Hierbei wird vor der Verstärkung von den modulierten Sensorsignalen von jeweils zwei der Phasen, die mit unterschiedlichem Vorzeichen gewichtet wurden und nach der Modulation einen Offset gleichen Vorzeichens aufweisen, ein aus den Sensorsignalen der zwei Phasen gemittelter Offset abgezogen. In einem Demodulator nach dem Verstärker erfolgt anschließend wieder eine Demodulation der modulierten Signale, bei der die Signale der einzelnen Phasen vorzeichenrichtig wieder zusammengesetzt werden. Durch eine vorzugsweise durchgeführte Filterung nach der Demodulation oder im Demodulator lässt sich der Offset des Verstärkers bei diesem Verfahren ebenfalls reduzieren. Bei einer derartigen Tiefpassfilterung werden in bekannter Weise die mit der Modulationsfrequenz oder einer höheren Frequenz modulierten Signalanteile blockiert.

Bei der Ausgestaltung des vorliegenden Verfahrens wurde erkannt, dass die Messgenauigkeit bei einem derartigen Mehrphasenbetrieb eines Sensors erhöht werden kann, wenn nicht nur der Gesamt-Offset der Signalverarbeitungskette zwischen dem Sensor und dem Ausgang der Sensor-Anordnung, sondern auch die Sensor-Signale der einzelnen Phasen getrennt voneinander im Offset reduziert werden. Mit dem Verfahren wird erreicht, dass bereits die am Verstärker ankommenden Sensor-Signale im Offset reduziert sind, so dass die Verstärkung nicht mehr durch den häufig größeren Offset begrenzt ist, sondern dem Messsignal wesentlich besser angepasst werden kann. Durch die somit bessere Ausnutzbarkeit des Aussteuerbereiches des Verstärkers lassen sich auch kleine Messsignale optimal weiterverarbeiten. Hierzu muss der Offset der Sensor-Signale noch nicht einmal ideal kompensiert werden. Der verbleibende Eigen-Offset muss nur deutlich geringer sein als die maximale Nutzsignal-Amplitude, die verarbeitet werden soll. Somit wird beim vorliegenden Verfahren nicht nur der Offset jeder Komponente für sich, d.h. des Sensors beispielsweise mit dem Spinning-Current-Verfahren und des Verstärkers mit dem Chopper-Verfahren, vermindert. Vielmehr wird der Gesamt-Offset der Signal-Verarbeitungskette aus Sensor und Verstärker so weit reduziert, dass sein Anteil am Aussteuerbereich der folgenden Signal-Verarbeitungskette, insbesondere dem Analog/Digital-Wandler oder einem Verstärker, im Vergleich zum eigentlichen Messsignal, beispielsweise dem magnetisch induzierten Signal-Hub bei einem Hall-Sensor, deutlich reduziert wird. Dies führt zu einer besseren Nutzung des Aussteuerbereiches durch das eigentliche Messsignal und somit zu einer höheren Auflösung bei der anschließenden Analog-Digital-Umsetzung, die in der höheren Genauigkeit resultiert.

In der vorliegenden Patentanmeldung wird nicht zwischen Verstärkern und Vorverstärkern unterschieden. Es kann sich somit bei dem Verstärker auch um einen oder mehrere Vorverstärker handeln.

Die Grundidee des vorliegenden Verfahrens besteht darin, im oder vor dem Verstärker künstlich einen zusätzlichen Offset zu erzeugen, der den Offset des Sensor-Signals der jeweiligen Phase des Messzyklus annähernd kompensiert.

Im Idealfall wäre hierdurch auch bereits die Kompensation des Offset des Sensors erreicht, so dass ein Mehrphasenbetrieb zu diesem Zweck dann nicht mehr erforderlich wäre. Allerdings ist eine derartige Offset-Kompensation in der Praxis nur bei exakt einer Temperatur und einer Betriebsspannung möglich, da der Offset der Einzelphasen nicht stabil ist. In der Realität schwanken die Einzelphasen-Offsets sehr stark über der Temperatur und der Betriebsspannung des Sensors. Weiterhin bleibt auch offen, ob ein derartig künstlich erzeugter Offset so lange stabil gehalten werden kann, wie es für die Kompensation des Sensor-Offset während des Betriebs des Sensors erforderlich wäre. Zusätzlich können sich die Einzelphasen-Offsets, beispielsweise aufgrund von mechanischen Spannungen im Sensor-Gehäuse, mit der Zeit ändern. Der künstlich eingebrachte Offset weist in der Regel einen anderen Temperatur-Gang auf als der des Sensors. Somit driften je nach Betriebsbedingungen die Offsets wieder auseinander, wobei die Korrelation der Einzelphasen-Offsets beim Mehrphasenbetrieb, die für eine Verbesserung des Offset durch die spätere Aufsummierung ursächlich ist, nicht durch den künstlichen Offset eines Verstärkers nachgebildet werden kann. Das am Ausgang der Sensor-Anordnung erhaltene Ausgangssignal hätte dann mit hoher Wahrscheinlichkeit einen größeren Offset als er ohne die zusätzliche Offset-Korrektur nur durch Anwendung des Mehrphasenbetriebs mit späterer Summation erreicht werden würde.

Auch diese Problematik wurde bei der Gestaltung des vorliegenden Verfahrens erkannt und durch eine geschickte Wahl der zusätzlichen Offset-Kompensation der Messsignale der einzelnen Phasen berücksichtigt. Hierbei werden die Einzelphasen-Offsets deutlich reduziert, ohne ihre Korrelation zueinander zu verlieren bzw. nicht korrelierte Offset-Anteile einzubringen. Zum einen wird der von den Messsignalen der einzelnen Phasen abgezogene künstliche Offset bei dem vorgeschlagenen Verfahren in einer besonderen Weise bestimmt. Zum anderen werden jeweils die um den gleichen künstlichen Offset reduzierten Messsignale in einer besonderen Weise moduliert. Dies wird im Folgenden anhand des Beispiels eines Hall-Sensors erläutert, der im Spinning-Current-Betrieb mit vier Phasen betrieben wird. Selbstverständlich lässt sich das Verfahren jedoch auch auf Hall-Sensoren anwenden, die mehr als vier Anschlüsse aufweisen und auch mit mehr als vier Phasen betrieben werden können. Weiterhin ist das vorliegende Verfahren wie auch die zugehörige Sensor-Anordnung nicht auf Hall-Sensoren beschränkt. So lässt sich mit dem Verfahren die Messgenauigkeit aller Sensoren verbessern, die in einem vergleichbaren Mehrphasenbetrieb eingesetzt werden und bei denen die Einzelphasen-Offsets eine gewisse Korrelation aufweisen. Beispiele sind Brückenschaltungen aus einzelnen Sensor-Elementen entsprechend dem Ersatzschaltbild für das Hall-Sensor-Element der Fig. 1.

Aus Messungen an Hall-Sensoren ist bekannt, dass immer zwei Spinning-Current-Phasen einen Einzelphasen-Offset mit gleichem Vorzeichen haben. Beim vorliegenden Verfahren werden nun zum einen jeweils zwei Phasen durch die Modulation mit unterschiedlichen Vorzeichen gewichtet, zum anderen wird der mittlere Offset der beiden Phasen, die nach der Modulation einen Offset gleichen Vorzeichens aufweisen, ermittelt und auf die (modulierten) Messsignale der beiden Phasen angewendet, d.h. von den Messsignalen abgezogen. Die gleiche Vorgehensweise wird für die beiden anderen Phasen gewählt, deren Offset ebenfalls das gleiche Vorzeichen hat. Durch diesen Schritt wird die Signalhöhe der am Verstärker anliegenden Messsignale gerade bei größeren Offsets deutlich reduziert, wie sie bei Hall-Elementen häufig auftreten. Dies ermöglicht eine höhere Verstärkung des eigentlichen Nutzsignals im Verstärker. Weiterhin erfolgt mit dieser Vorgehensweise eine Symmetrierung der verbleibenden Offsets der jeweils zwei Phasen um den Nullpunkt. Der Aussteuerbereich des Analog/Digital-Umsetzers wird damit zum einen symmetrisch ausgenutzt und kann zum anderen die Messsignale aufgrund der möglichen höheren Verstärkung mit höherer Genauigkeit wandeln.

Der Korrekturwert des Offset für die jeweils zwei Phasen muss nicht langzeitstabil sein und darf auch eine gewisse Variation über der Temperatur und anderen Betriebsparametern aufweisen. Dies ist beim vorliegenden Verfahren unschädlich, da er aufgrund der besonderen Modulation der Messsignale einmal positiv und einmal negativ gewichtet nach der Demodulation erhalten wird und somit bei der Aufsummierung der Messsignale jedes Messzyklus wieder systematisch aus dem Gesamtmesswert eliminiert wird. Der künstlich erzeugte Offset spielt somit nur im Bereich zwischen dem Sensor und dem Demodulator eine Rolle und geht nicht in das Ergebnis des Spinning-Current-Verfahrens ein. Das bereits gute Ergebnis der Offset-Kompensation mit diesem Verfahren wird daher nicht verschlechtert. Auf der anderen Seite werden jedoch die zur Verfügung stehenden Aussteuerbereiche des Verstärkers und Analog/Digital-Umsetzers besser ausgenutzt, so dass eine höhere Auflösung bei der Analog/Digital-Umsetzung erzielt werden kann. Dies erhöht die Messgenauigkeit der Sensor-Anordnung.

Vorzugsweise erfolgt beim vorliegenden Verfahren die Demodulation der modulierten Messsignale erst nach der Analog/Digital-Umsetzung. Dies bietet den Vorteil, dass die Demodulation digital, beispielsweise mit einem Dezimationsfilter, erfolgen kann.

In einer weiteren bevorzugten Ausgestaltung wird die Sensor-Anordnung im so genannten Nested-Chopper-Verfahren betrieben, bei dem unmittelbar vor und hinter dem Verstärker ein zusätzlicher Modulator und Demodulator vorgesehen sind. Die Modulation erfolgt hierbei mit einer höheren Frequenz als die Modulation mit dem ersten Modulator, um eine bessere Unterdrückung des Verstärker-Offsets sowie des 1/f-Rauschens des Verstärkers zu erzielen.

Die vorgeschlagene Sensor-Anordnung zur Durchführung des Verfahrens weist den Sensor mit einer Ansteuereinheit auf, durch die der Sensor in dem beschriebenen Mehrphasenbetrieb betrieben werden kann. Zwischen dem Sensor und einem Verstärker zur Verstärkung der modulierten Sensorsignale ist ein Modulator vorgesehen, der die Sensorsignale gemäß dem vorgeschlagenen Verfahren moduliert. Eine Offset-Quelle zwischen dem Modulator und dem Verstärker dient der Reduktion der Sensor-Signale um den gemäß dem Verfahren bestimmten künstlichen Offset, der für die jeweils zwei Phasen genutzt wird. Ein Analog/Digital-Wandler sowie ein Demodulator hinter dem Verstärker dienen der Digitalisierung der Sensor-Signale bzw. der Demodulation der modulierten und verstärkten Signale. Vorzugsweise ist hierbei der Analog/Digital-Wandler zwischen dem Verstärker und dem Demodulator, vorzugsweise einem Dezimationsfilter, angeordnet. Weiterhin lassen sich selbstverständlich auch bei dieser Sensor-Anordnung zusätzliche Komponenten zur Offset-Reduzierung einsetzen, beispielsweise ein zusätzlicher Modulator und Demodulator zum Betrieb der Sensor-Anordnung mit einem Nested-Chopper-Verfahren, wie es aus dem Stand der Technik bekannt ist.

### Kurze Beschreibung der Zeichnungen

Das vorgeschlagene Verfahren sowie die zugehörige Sensor-Anordnung werden im Folgenden anhand von Ausführungsbeispielen in Verbindung mit den Zeichnungen nochmals näher erläutert. Hierbei zeigen:
- Fig. 1: eine Darstellung zur Veranschaulichung der vier Phasen beim Spinning-Current-Betrieb eines Hall-Sensors;
- Fig. 2: ein Beispiel für gemessene Sensor-Signale eines Hall-Elements in den vier Phasen;
- Fig. 3: ein Beispiel für ein Chopper-Verfahren;
- Fig. 4: eine Veranschaulichung der bei dem Chopper- Verfahren erhaltenen Signale;
- Fig. 5: eine beispielhafte Darstellung der Ausgangssignale eines Chopper-Verfahrens;
- Fig. 6: ein Beispiel für die vorgeschlagene Sensor- Anordnung und das zugehörige Verfahren;
- Fig. 7: ein Beispiel für die Bestimmung der künstlichen Offsets bei dem vorliegenden Verfahren;
- Fig. 8: ein Beispiel für die um den künstlichen Offset reduzierten Sensor-Signale;
- Fig. 9: das Beispiel der Fig. 8 nach der Demodulation;
- Fig. 10: den sich bei dem Beispiel ergebenden Spinning- Current(SC)-Ausgangswert;
- Fig. 11: ein erstes Beispiel für die Einstellung des künstlichen Offsets, der von den Sensor- Signalen abgezogen wird;
- Fig. 12: ein zweites Beispiel für die Einstellung des künstlichen Offsets, der von den Sensor- Signalen abgezogen wird; und
- Fig. 13: ein weiteres Beispiel für die Ausgestaltung der vorgeschlagenen Sensor-Anordnung.

### Wege zur Ausführung der Erfindung

Das vorliegende Verfahren und die zugehörige Sensor-Anordnung werden im Folgenden anhand von Beispielen näher erläutert, bei denen ein Hall-Sensor mit vier Kontakten bzw. Anschlüssen mit der Spinning-Current-Technik mit vier Phasen pro Messzyklus betrieben wird. Ein derartiger Betrieb sowie beispielhafte Sensorsignale der unterschiedlichen Phasen wurden bereits in der Beschreibungseinleitung in Zusammenhang mit den Fig. 1 und 2 beschrieben. Auf diese Figuren wird daher an dieser Stelle nicht mehr eingegangen.

Das Gleiche gilt für die Fig. 3 bis 5, die das Chopper-Verfahren zur Offset-Reduzierung der Sensor-Signale eines Sensors sowie die dabei auftretende schlechte Ausnutzung des Aussteuerbereiches des Verstärkers veranschaulichen.

Alle bisher bekannten Verfahren zur Reduzierung des Verstärker-Offset haben gemeinsam, dass nur der Offset des Verstärkers selbst reduziert bzw. eliminiert wird. Offset-Anteile, die in der Signalquelle vor dem Verstärker entstehen, werden durch diese Maßnahme nicht berührt. Der Offset von Hall-Elementen lässt sich zwar durch Anwendung des Spinning-Current-Verfahrens deutlich vermindern. Allerdings müssen auch dazu zunächst die Sensorsignale aller Spinning-Current-Phasen inklusive des Offset der Einzelphasen verstärkt und digitalisiert werden. Hierzu reduziert der Offset der jeweiligen Einzelphase zusammen mit dem Offset des Verstärkers den maximal möglichen Verstärkungsfaktor des Verstärkers. Dessen Ausgangsbereich bzw. der Eingangsbereich des nachfolgenden Signal-Verarbeitungsblocks, beispielsweise weitere Verstärkungsstufen oder ein Analog/Digital-Umsetzer, erlaubt nur eine begrenzte Signal-Amplitude, die bei Hall-Sensor-Systemen aufgrund der relativ geringen Empfindlichkeit der Sensoren zum größten Teil bereits durch Offsets beansprucht wird.

Bei dem vorliegenden Verfahren wird demgegenüber der Gesamt-Offset der Signal-Verarbeitungskette aus Hall-Sensor und Verstärker so weit reduziert, dass sein Anteil am Aussteuerbereich der folgenden Signal-Verarbeitungskette (Verstärker bzw. ADU) im Vergleich zum magnetisch induzierten Signal-Hub (Nutzsignal) deutlich reduziert wird. Derzeit liegt dieser Anteil in der Regel etwa zwischen 60% und 80%. Das bedeutet, dass der Signal-Anteil nur bei 20 bis 40% liegt. Wünschenswert wäre ein Anteil des Offsets von maximal 50% des Aussteuerbereiches, so dass der Signal-Anteil auf über 50% ansteigt. Dann würde der magnetische Signal-Hub selbst die bestimmende Größe für die Dimensionierung der Verstärkung darstellen und nicht mehr der Offset. Dies darf jedoch auf der anderen Seite nicht dazu führen, dass der Offset des Ausgangssignals nach Anwendung der Spinning-Current-Summation verschlechtert wird.

Dies wird bei dem nachfolgenden Beispiel dadurch erreicht, dass die Signal-Verarbeitungskette um eine Offset-Spannungsquelle 8 ergänzt wird, wie dies in der Fig. 6 schematisch dargestellt ist. Die Sensor-Signale der unterschiedlichen Phasen eines Messzyklus des Hall-Sensors 6 werden hierbei in einem Modulator 7 in einer bestimmten Weise moduliert. Von den modulierten Signalen wird anschließend über die Offset-Quelle 8 ein vorbestimmter künstlicher Offset O₁, O₂ abgezogen. Die auf diese Weise korrigierten Sensor-Signale werden im Verstärker 9 verstärkt und anschließend im Analog/Digital-Umsetzer 10 (ADU) digitalisiert.

Bei der Modulation werden zwei der vier Phasen positiv und zwei Phasen negativ durch den Modulator 7 gewichtet. Dieser Vorzeichenwechsel des Verstärker-Eingangssignals wird bei der Dezimation im Dezimationsfilter 11 nach dem Verstärker als Vorzeichen berücksichtigt, so dass am Ende aller vier Phasen wieder das korrekte Signal im Dezimationsfilter 11 vorliegt. Aufgrund der wechselnden Vorzeichen, mit denen das Sensor-Signal in die Signal-Verarbeitungskette eingespeist wird, wird der zusätzliche künstliche Offset - genauso wie der Eigen-Offset des Verstärkers und des ADU's - durch das Chopper-Verfahren im Endergebnis der Summe über alle Spinning-Current-Phasen wieder eliminiert. Dies funktioniert unabhängig von Temperatur und anderen Betriebsbedingungen.

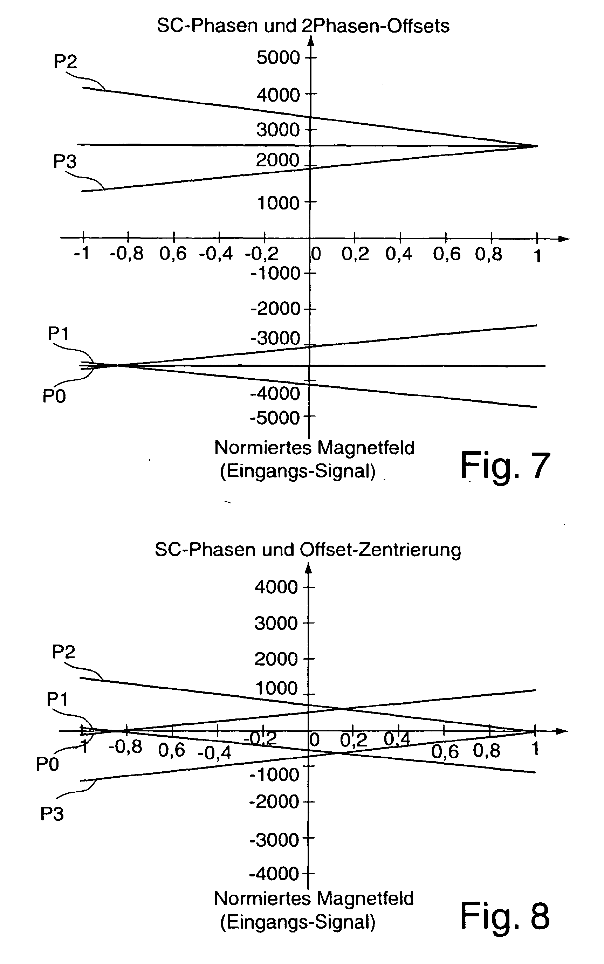

Aus Messungen an Hall-Sensoren ist bekannt, dass immer zwei Spinning-Current-Phasen einen Einzelphasen-Offset mit gleichem Vorzeichen haben, wie dies auch aus dem Diagramm der Fig. 2 ersichtlich ist. Der Offset der Spinning-Current-Phasen P0 und P2 hat hierbei das gleiche Vorzeichen. Das Gleiche gilt für den Offset der Spinning-Current-Phasen P1 und P3. Der gesamte Signal-Bereich aller vier Einzelphasen deckt den Wertebereich von ca. -4000 bis +5000 ab. Da jedoch der Offset eine stochastische Größe ist, die von Sensor zu Sensor streut, wird man das System so auslegen, dass der Signal-Bereich des ADUs (Analog/Digital-Umsetzer) in beide Richtungen an den maximalen Offset der Sensoren angepasst ist und somit etwa von -5000 bis +5000 reicht. Das sind etwa 10.000 Quantisierungsstufen des Analog/Digital-Umsetzers. Bei dem vorliegenden Verfahren wird nun der mittlere Offset der jeweils beiden Phasen, die nach der Modulation einen Offset gleichen Vorzeichens aufweisen, bestimmt und vor dem Eingang des Verstärkers auf diese beiden Phasen angewendet, d.h. von den Messsignalen dieser beiden Phasen abgezogen. Fig. 7 zeigt hierzu die Messsignale der vier Spinning-Current-Phasen nach der Modulation in Abhängigkeit vom Magnetfeld sowie den jeweils gebildeten mittleren Offset O₁ bzw. O₂. Werden die Sensor-Signale der Einzelphasen jeweils um die gemeinsamen Offsets O₁, O₂ für die jeweils zwei Spinning-Current-Phasen korrigiert, wie dies in Fig. 8 veranschaulicht ist, dann wird der Wertebereich für die Messungen aller vier Spinning-Current-Phasen auf den Bereich von etwa -1800 bis +1800 reduziert. Dies sind etwa 3600 Quantisierungsstufen. Der Aussteuerungsbereich des Analog/ Digital-Umsetzers wird dadurch zum einen symmetrisch ausgenutzt. Der Offset der Spinning-Current-Phasen liegt nun symmetrisch zur Rechtswert-Achse, weshalb die vorliegende Technik auch als Offset-Symmetrierung bezeichnet werden kann. Zum anderen kann die Verstärkung in diesem Beispiel nun um den Faktor 10000/3600 = 2,8 erhöht werden, was die Auflösung des Signals ebenfalls um den Faktor 2,8 verbessert. Das führt immerhin zu einer Erhöhung der Auflösung des Signals um 1,5 Bit.

Die Korrektur des Offset erfolgte in diesem Beispiel mit einem gemeinsamen Korrektur-Offset für die Phasen P0 und P1 und einem gemeinsamen Korrektur-Offset für die Phasen P2 und P3. Bei einem anderen Hall-Sensor können es selbstverständlich auch andere Kombinationen der Phasen sein. Auch die Modulation kann anders ausgeführt werden, so dass nicht wie im vorliegenden Beispiel die erste Phase positiv, die zweite Phase negativ, die dritte Phase positiv und die vierte Phase negativ gewichtet werden (oder umgekehrt), sondern beispielsweise die erste und vierte Phase positiv und die zweite und dritte Phase negativ.

Ein wesentlicher Vorteil der vorgeschlagenen Vorgehensweise liegt - wie bereits erläutert - darin, dass der Korrekturwert nicht langzeitstabil sein muss und auch eine gewisse Variation über der Temperatur und anderen Betriebsparametern haben kann. Aus dem Gesamtmesswert wird er wieder systematisch eliminiert, da er einmal positiv und einmal negativ gewichtet bei der Summation, die auch im Dezimationsfilter erfolgen kann, am Ende der Kette ankommt. Voraussetzung dafür ist, dass immer zwei Phasen gemeinsam im Offset korrigiert werden, die mit unterschiedlichen Vorzeichen durch die Chopper-Anordnung verarbeitet werden. Dann wird das Endergebnis des Spinning-Current-Verfahrens durch die Offset-Symmetrierung nicht beeinträchtigt. Das Messergebnis ist dasselbe, nur mit dem Unterschied, dass der Aussteuerbereich des beteiligten Verstärkers und des Analog/Digital-Umsetzers besser ausgenutzt wird und dadurch die Auflösung des Messergebnisses höher ist.

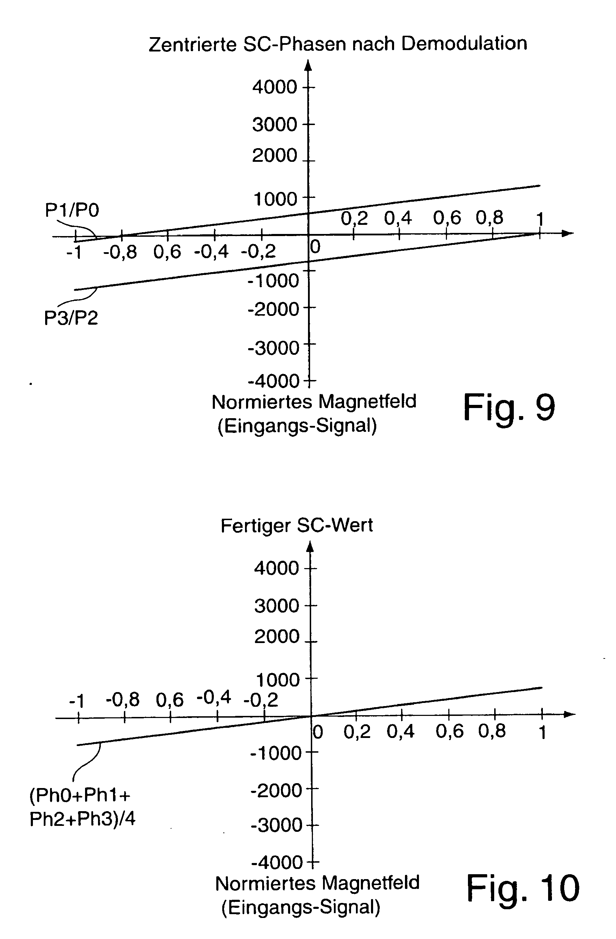

Fig. 9 zeigt die vier Spinning-Current-Phasen nach der Offsetkorrektur und der anschließenden Demodulation. In Fig. 10 ist das nach der vollständigen Durchführung des Spinning-Current-Verfahrens, d.h. nach der Mittelung über alle vier Phasen, erhaltene Ausgangssignal dargestellt. Wie man am Spinning-Current-Ergebnis sieht, ist der Aussteuerbereich immer noch stark von Einzelphasen-Offsets geprägt. Das Sensor-Signal ohne Offset besitzt einen Wertebereich von etwa -700 bis +700, was einer Spanne von 1400 Quantisierungsstufen entspricht. Der verbleibende Einzelphasen-Offset durch die Offset-Symmetrierung beträgt immer noch etwa ± 1150, also 2300 Quantisierungsstufen. Dennoch ist die Auflösung und somit die Messgenauigkeit gegenüber den bisher bekannten Verfahren um mindestens 1 Bit erhöht.

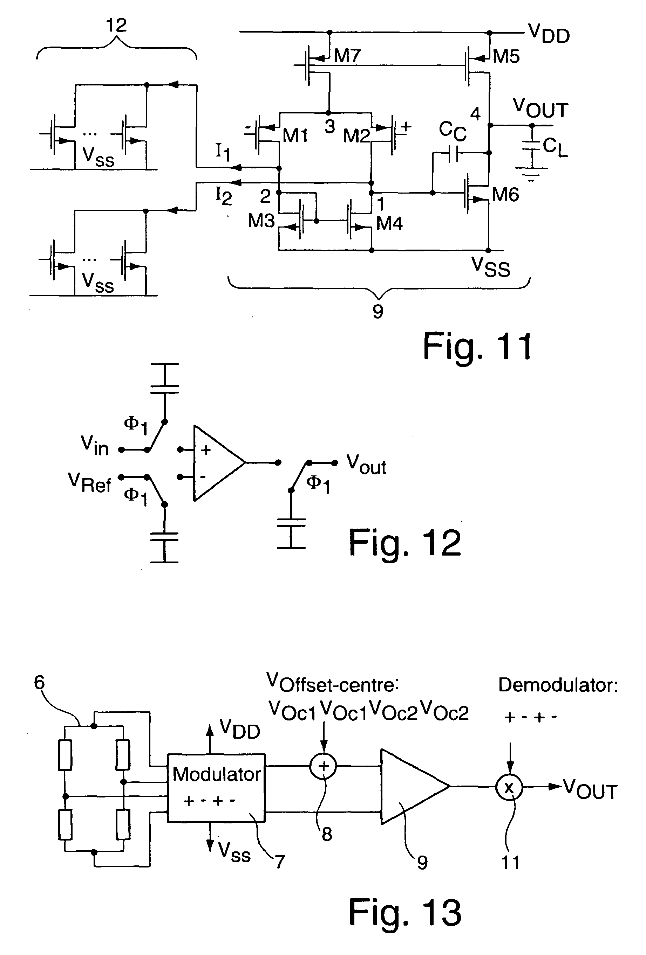

Fig. 11 zeigt ein Beispiel einer Umsetzung der vorgeschlagenen Offset-Zentrierung bei Einsatz einer linearen Differenz-Eingangsstufe als Verstärker.

Bei einer differentiellen Eingangsstufe eines linearen Verstärkers lässt sich der Offset über programmierbare Stromquellen steuern. Diese programmierbaren Stromquellen sind in der Figur mit dem Bezugszeichen 12 angedeutet. Über diese gemäß dem gewünschten künstlichen Offset einstellbaren Stromquellen lässt sich dieser von den Eingangssignalen des linearen Verstärkers 9 subtrahieren.

Bei SC-Schaltungen (SC: Switched Capacitor) kann der Offset auch über eine geschaltete Kapazität zusammen mit einer gesteuerten Spannungsquelle (V_{Ref}) eingestellt werden, wie dies in der Fig. 12 dargestellt ist.

Fig. 13 zeigt schließlich nochmals eine beispielhafte Ausgestaltung der vorliegenden Sensor-Anordnung mit einem Hall-Sensor 6, einem Modulator 7, der Offset-Quelle 8, dem Verstärker 9 und dem Demodulator 11. Der ADU ist in dieser Figur nicht eingezeichnet. Anhand der Fig. 13 kann die Arbeitsweise des vorliegenden Verfahrens und die Auswirkung auf die Signale nochmals nachvollzogen werden. Vor dem Modulator haben die Sensor-Signale der einzelnen Phasen die Werte +V_{Sig} + V_{Off0} (Phase P0), +V_{Sig} + V_{Off1} (Phase P1), +V_{Sig} + V_{Off2} (Phase P2) und +V_{Sig} + V_{Off3} (Phase P3). V_{Sig} entspricht dabei dem eigentlichen Nutzsignal, d.h. dem durch den magnetischen Hub idealerweise gemessenen Signal. V_{Off} entspricht dem Offset des Hall-Sensors in der jeweiligen Phase. Die Signale der einzelnen Phasen werden dann im Modulator in der in der nachfolgenden Tabelle angeordneten Weise mit positivem oder negativem Vorzeichen gewichtet. Nach dem Modulator wird durch die Offset-Quelle 8 der jeweilige über zwei Phasen gemittelte Offset V_{Oc1} bzw. V_{Oc2} abgezogen. Das entsprechend kleinere Signal vor dem Verstärker wird dann verstärkt und im Demodulator mit dem korrekten Vorzeichen wieder demoduliert. Der Tabelle können die Signale vor dem Verstärker, das Vorzeichen im Demodulator sowie das Ausgangssignal aus dem Demodulator Vₒᵤₜ entnommen werden. Nach Anwendung der Summierung des Spinning-Current-Verfahrens ergibt sich dann zumindest annähernd das vierfache Messsignal 4 x V_{Sig}. Aufgrund der Eigenschaften (Betrag und Vorzeichen) der Offset-Anteile V_{Off0}, V_{Off1}, V_{Off2} und V_{Off3} heben sich diese gegenseitig auf, wenn die Signale der vier Spinning-Current-Phasen aufsummiert werden. Darauf beruht das Spinning-Current-Verfahren zur Reduktion des Offsets von Hall-Elementen.

**Tabelle 1: Modulation und Demodulation aller 4 Phasen**

| Chopper- bzw. Spinning-Current-Phase | 0 | 1 | 2 | 3 |
|---|---|---|---|---|
| Signal vor Modulator | +V_{Sig}+V_{Off0} | +V_{Sig}+V_{Off1} | +V_{Sig}+V_{Off2} | +V_{Sig}+V_{Off3} |
| Vorzeichen im Modulator | + | - | + | - |
| Signal nach Modulator | +V_{Sig}+V_{Off0} | - V_{Sig}-V_{Off1} | +V_{Sig}+V_{Off2} | -V_{Sig}-V_{Off3} |
| V_{offset-centre} | V_{Oc1} | V_{Oc1} | V_{Oc2} | V_{Oc2} |
| Signal vor Verstärker | V_{Oc1}+V_{Sig}+V_{Off0} | V_{Oc1}-V_{Sig}-V_{Off1} | V_{Oc2}+V_{Sig}+V_{Off2} | V_{Oc2}-V_{Sig}-V_{Off3} |
| Vorzeichen im Demodulator | + | - | + | - |
| Vₒᵤₜ | V_{Oc1}+V_{Sig}+V_{Off0} | -V_{Oc1}+V_{Sig}+V_{Off1} | V_{Oc2}+V_{Sig}+V_{Off2} | -V_{Oc2}+V_{Sig}+V_{Off3} |
| alle vier Phasen aufsummiert | 4·V_{Sig}+V_{Off0}+V_{Off1}+V_{Off2}+V_{Off3} ≈ 4·V_{Sig} | | | |

Mit dem vorgeschlagenen Verfahren wird der Aussteuerbereich der Signal-Kette (Verstärker und ADU) symmetrisch ausgesteuert. Das Verfahren ermöglicht, den Verstärkungsfaktor des Verstärkers zu erhöhen, so dass das Signal/Rausch-Verhältnis verbessert wird. Außerdem wird dadurch der Aussteuerbereich der ADU's besser ausgenutzt und damit die Auflösung des Messwertes erhöht. Der Messwert wird nicht verfälscht, da der beim vorliegenden Verfahren künstlich hinzugefügte Offset aufgrund des Chopper-Verfahrens wieder systematisch entfernt wird.

Die Offsets der einzelnen Phasen müssen beim vorliegenden Verfahren vorab für jeden Sensor gemessen werden, damit der jeweils mittlere Offset für zwei Phasen mit gleichem Vorzeichen des Offsets ermittelt werden kann. Allerdings ist bei Messungen mit hoher Genauigkeit von vorneherein eine Kalibrierung des Systems erforderlich, so dass sich der zusätzliche Aufwand in Grenzen hält.

### BEZUGSZEICHENLISTE

| | |
|---|---|
| 1 | Modulator |
| 2 | Verstärker |
| 3 | Demodulator |
| 4 | Tiefpassfilter |
| 5 | Offset-Quelle |
| 6 | Hall-Sensor |
| 7 | Modulator |
| 8 | Offset-Spannungsquelle |
| 9 | Verstärker |
| 10 | Analog/Digital-Wandler |
| 11 | Dezimationsfilter |
| 12 | Gesteuerte Stromquellen |

## Patentansprüche

1. Verfahren zur Verarbeitung von mit einem Offset behafteten Sensorsignalen eines Sensors (6), der in mehreren Messzyklen mit jeweils 2n (n=1,2..) aufeinander folgenden Phasen mit unterschiedlicher Ansteuerung betrieben wird,
bei dem die Sensorsignale der einzelnen Phasen in einem Verstärker (9) verstärkt und anschließend mit einem Analog/Digital-Wandler (10) digitalisiert werden, und bei dem die verstärkten digitalisierten Signale der einzelnen Phasen jedes Messzyklus aufsummiert werden, um für jeden Messzyklus ein Offset-reduziertes Ausgangssignal zu erhalten, wobei die Sensorsignale vor der Verstärkung in einem Modulator (1) moduliert und nach der Verstärkung in einem Demodulator (3) wieder demoduliert werden, wobei
durch die Modulation die Sensorsignale von n Phasen jedes Messzyklus mit negativem Vorzeichen und die Sensorsignale der verbleibenden n Phasen des Messzyklus mit positivem Vorzeichen gewichtet werden und
vor der Verstärkung von den modulierten Sensorsignalen von jeweils zwei Phasen, die mit unterschiedlichem Vorzeichen gewichtet wurden und nach der Modulation einen Offset gleichen Vorzeichens aufweisen, ein aus den Sensorsignalen der zwei Phasen gemittelter Offset abgezogen wird.

2. Verfahren nach Anspruch 1,
**dadurch gekennzeichnet,**
**dass** die Demodulation nach der Digitalisierung erfolgt.

3. Verfahren nach Anspruch 1 oder 2 zur Verarbeitung von Sensorsignalen eines Hallsensors, der im Spinning-Current Betrieb mit zumindest 4 Phasen
betrieben wird.

4. Verfahren nach einem der Ansprüche 1 bis 3,
**dadurch gekennzeichnet,**
**dass** die Sensorsignale in der Weise eines Nested Chopper Verfahrens nach der Subtraktion des mittleren Offsets in einem zweiten Modulator vor der Verstärkung zusätzlich mit einer zweiten, höheren Frequenz moduliert werden, die eine Reduzierung eines 1/f-Rauschens des Verstärkers ermöglicht, nach der Verstärkung gefiltert werden und nach der Filterung mit einem zweiten Demodulator bezüglich der zweiten Frequenz wieder demoduliert werden.

5. Sensoranordnung mit
- einem Sensor (6)
- einer Ansteuereinheit, durch die der Sensor in mehreren Messzyklen mit jeweils 2n (n=1,2..) aufeinander folgenden Phasen mit unterschiedlicher Ansteuerung betreibbar ist,
- einem Modulator (1) zur Modulation der Sensorsignale des Sensors (6),
- einem Verstärker (9) zur Verstärkung der modulierten Sensorsignale,
- einem Analog/Digital-Wandler (10) zur Digitalisierung der verstärkten Sensorsignale,
- und einem Demodulator (3) zur Demodulation der verstärkten und/oder digitalisierten Sensorsignale, wobei
der Modulator (1) derart ausgebildet ist, dass er die Sensorsignale von n Phasen jedes Messzyklus mit negativem Vorzeichen und die Sensorsignale der verbleibenden n Phasen des Messzyklus mit positivem Vorzeichen gewichtet, und
eine Offset-Reduktionseinheit (8) vorgesehen ist, die vor der Verstärkung von den modulierten Sensorsignalen von jeweils zwei der Phasen, die mit unterschiedlichem Vorzeichen gewichtet wurden und nach der Modulation einen Offset gleichen Vorzeichens aufweisen, einen aus dem Offset der zwei Phasen gemittelten Offset abzieht.

6. Sensoranordnung nach Anspruch 5,
**dadurch gekennzeichnet,**
**dass** der Sensor (6) ein Hall-Sensor ist.

7. Sensoranordnung nach Anspruch 6,
**dadurch gekennzeichnet,**
**dass** der Hall-Sensor ein durch die Ansteuereinheit im Spinning-Current Betrieb mit zumindest 4 Phasen betreibbarer Hall-Sensor ist.

8. Sensoranordnung nach einem der Ansprüche 5 bis Anspruch 7,
**dadurch gekennzeichnet,**
**dass** der Demodulator (3) ein Dezimationsfilter (11) ist, der dem Analog/Digital-Wandler (10) nachgeschaltet ist.

## Claims

1. A method for processing sensor signals, which are subject to an offset, of a sensor (6), which is operated in a plurality of measurement cycles with 2n (n = 1, 2,...) successive phases each with different driving,
in which the sensor signals of the individual phases are amplified in an amplifier (9) and subsequently digitized using an analog/digital converter (10), and in which the amplified digitized signals of the individual phases of each measurement cycle are summed to obtain an offset-reduced output signal for each measurement cycle,
the sensor signals being modulated before the amplification in a modulator (1) and demodulated again after the amplification in a demodulator (3),
wherein by the modulation, the sensor signals of n phases of each measurement cycle are weighted with negative mathematical sign and the sensor signals of the remaining n phases of the measurement cycle are weighted with positive mathematical sign, and
before the amplification of the modulated sensor signals of each two phases which were weighted with different mathematical sign and have an offset of the same mathematical sign after the modulation, an offset averaged from the sensor signals of the two phases is subtracted.

2. The method according to Claim 1,
**characterized in that** the demodulation is performed after the digitization.

3. The method according to Claim 1 or 2 for processing sensor signals of a Hall sensor, which is operated in spinning current operation with at least 4 phases.

4. The method according to one of Claims 1 through 3, **characterized in that** the sensor signals are additionally modulated with a second, higher frequency in the meaning of a nested chopper method after the subtraction of the mean offset in a second modulator before the amplification, which allows a reduction of a 1/f noise of the amplifier, are filtered after the amplification, and are demodulated again with a second demodulator in regard to the second frequency after the filtering.

5. A sensor arrangement having
- a sensor (6)
- an activation unit, by which the sensor is operable in a plurality of measurement cycles each having 2n (n = 1, 2,...) successive phases with different driving,
- a modulator (1) for modulating the sensor signals of the sensor (6),
- an amplifier (9) for amplifying the modulated sensor signals,
- an analog/digital converter (10) for digitizing the amplified sensor signals,
- and a demodulator (3) for demodulating the amplified and/or digitized sensor signals,
wherein the modulator (1) is implemented in such a way that it weights the sensor signals of n phases of each measurement cycle with negative mathematical sign and the sensor signals of the remaining n phases of the measurement cycle with positive mathematical sign, and an offset reduction unit (8) is provided which, before the amplification of the modulated sensor signals of each two of the phases which were weighted with different mathematical sign and have an offset of the same mathematical sign after the modulation, subtracts an offset averaged from the offset of the two phases.

6. The sensor arrangement according to Claim 5,
**characterized in that** the sensor (6) is a Hall sensor.

7. The sensor arrangement according to Claim 6,
**characterized in that** the Hall sensor is a Hall sensor operable by the activation unit in spinning current operation with at least 4 phases.

8. The sensor arrangement according to one of Claims 5 through 7,
**characterized in that** the demodulator (3) is a decimation filter (11) which is connected downstream from the analog/digital converter (10).

## Revendications

1. Procédé de traitement de signaux de capteurs affectés d'un décalage d'un capteur (6) qui est exploité en plusieurs cycles de mesure avec des phases se suivant respectivement de 2n (n=1, 2...) avec une commande différente,
dans lequel les signaux de capteur des différentes phases sont amplifiés dans un amplificateur (9) puis numérisés avec un convertisseur analogique/numérique (10) et dans lequel les signaux numérisés amplifiés des différentes phases de chaque cycle de mesure sont additionnés afin d'obtenir un signal de départ réduit du décalage pour chaque cycle de mesure, sachant que les signaux de capteur sont modulés dans un modulateur (1) avant l'amplification et de nouveau démodulés dans un démodulateur (3) après l'amplification, sachant que par la modulation, les signaux de capteur de n phases de chaque cycle de mesure sont pondérés avec un signe négatif et les signaux de capteur des phases n restantes du cycle de mesure sont pondérés avec un signe positif, et avant l'amplification des signaux de capteur modulés de deux phases respectives, qui ont été pondérés avec un signe différent et présentent après la modulation un décalage de même signe, on déduit un décalage calculé à partir du décalage des deux phases.

2. Procédé selon la revendication 1, **caractérisé en ce que** la démodulation a lieu après la numérisation.

3. Procédé selon la revendication 1 ou 2 pour le traitement de signaux de capteurs d'un capteur à effet Hall qui fonctionne avec un « spinning current » avec au moins 4 phases.

4. Procédé selon l'une des revendications 1 à 3, **caractérisé en ce que** les signaux de capteur sont en plus modulés à la manière d'un procédé Nested Chopper, après la soustraction du décalage moyen dans un deuxième modulateur avant l'amplification, avec une deuxième fréquence plus élevée qui permet une réduction d'un bruit 1/f de l'amplificateur, sont filtrés après l'amplification et sont de nouveau démodulés avec un deuxième démodulateur par rapport à la deuxième fréquence après la filtration.

5. Agencement de capteurs comprenant
- un capteur (6)
- une unité de commande par laquelle le capteur peut fonctionner en différents cycles de mesure avec des phases se suivant respectivement de 2n (n=1, 2...) avec une commande différente,
- un modulateur (1) pour moduler les signaux du capteur (6),
- un amplificateur (9) pour amplifier les signaux de capteur modulés,
- un convertisseur analogique/numérique (10) pour numériser les signaux de capteur amplifiés,
- et un démodulateur (3) pour démoduler les signaux de capteur amplifiés et/ou numérisés,
dans lequel le modulateur (1) est ainsi formé qu'il pondère les signaux de capteur de n phases de chaque cycle de mesure sont avec un signe négatif et pondère les signaux de capteur des phases n restantes du cycle de mesure avec un signe positif, et
une unité de réduction du décalage (8) est prévue qui, avant l'amplification des signaux de capteur modulés de deux des phases respectives, qui ont été pondérés avec un signe différent et présentent après la modulation un décalage de même signe, déduit un décalage calculé à partir du décalage des deux phases.

6. Agencement de capteurs selon la revendication 5, **caractérisé en ce que** le capteur (6) est un capteur à effet Hall.

7. Agencement de capteurs selon la revendication 6, **caractérisé en ce que** le capteur à effet Hall est un capteur à effet Hall qui peut être exploité par l'unité de commande en fonctionnement par « spinning current » avec au moins 4 phases.

8. Agencement de capteurs selon l'une des revendications 5 à 7, **caractérisé en ce que** le démodulateur (3) est un filtre de décimation (11) monté en aval du convertisseur analogique/numérique (10).
